# EUROPÄISCHE PATENTSCHRIFT

(11) **EP 4 275 869 B1**
(45) Veröffentlichungstag und Bekanntmachung des Hinweises auf die Patenterteilung: **19.02.2025**
(21) Anmeldenummer: 23162139.2
(22) Anmeldetag: 15.03.2023
(51) Int. Cl.: B29C 64/135, B29C 64/232, B29C 64/393, B29C 64/255

(54) **VERFAHREN UND VORRICHTUNG ZUM ERZEUGEN EINER DREIDIMENSIONALEN STRUKTUR IN EINEM LITHOGRAPHIEFLUID**
METHOD AND DEVICE FOR PRODUCING A THREE-DIMENSIONAL STRUCTURE IN A LITHOGRAPHY FLUID
PROCÉDÉ ET DISPOSITIF DE GÉNÉRATION D'UNE STRUCTURE TRIDIMENSIONNELLE DANS UN FLUIDE LITHOGRAPHIQUE

(30) Priorität: 11.05.2022 DE 102022111789
(43) Veröffentlichungstag der Anmeldung: 15.11.2023
(73) Patentinhaber: Nanoscribe Holding GmbH, 76344 Eggenstein-Leopoldshafen (DE)
(72) Erfinder: HIPPLER, Marc, 76344 Eggenstein-Leopoldshafen (DE); THIEL, Michael, 76135 Karlsruhe (DE)
(74) Vertreter: DREISS Patentanwälte PartG mbB

(56) Entgegenhaltungen:
- EP-A2- 1 769 901
- DE-A1- 4 414 775
- US-A- 5 922 364

## Beschreibung

Die Erfindung betrifft ein Verfahren zum Erzeugen einer dreidimensionalen Zielstruktur in einem Lithographiefluid mittels einer Lithographievorrichtung. Die Erfindung betrifft auch eine für das Verfahren angepasste und ausgebildete Lithographievorrichtung.

Bei den im vorliegenden Zusammenhang betrachteten Lithographie-Techniken erfolgt das Schreiben einer Struktur insbesondere dadurch, dass ein Schreibstrahl entlang einer optischen Achse in ein Lithographiematerial derart eingestrahlt wird, dass in einem Fokusbereich des Schreibstrahls das Lithographiematerial lokal verfestigt wird und somit ein Strukturbereich bzw. "Voxel" definiert wird. Beispielsweise ist es denkbar, dass das Lithographiematerial in dem Fokusbereich durch den Schreibstrahl lokal ausgehärtet oder polymerisiert wird. Um eine zwei- oder dreidimensionale Gesamtstruktur zu schreiben, wird der Fokusbereich innerhalb des Lithographiematerials verlagert (gescannt), sodass sequenziell eine Mehrzahl von Volumenelementen ("Voxeln") definiert werden, die sich insgesamt zu der Gesamtstruktur ergänzen.

Eine entsprechende Technik unter Ausnutzung des physikalischen Prinzips der Zwei-Photonen-Polymerisation oder allgemein der Multi-Photonen-Polymerisation ist beispielsweise in der DE 10 2017 110 241 A1 beschrieben. Derartige Techniken finden insbesondere Verwendung bei der Erzeugung von Mikro- oder Nanostrukturen in Bereichen, in welchen hohe Präzision und gleichzeitig Gestaltungsfreiheit für die zu erzeugende Struktur erwünscht sind.

Bei den beschriebenen Techniken ist das Lithographiematerial in der Regel ein flüssiges oder visköses Lithographiefluid, welches in einem Lithographiebad bereitgestellt ist. Zur Erzeugung einer Zielstruktur in dem Lithographiefluid kann dann der Schreibstrahl durch eine Oberfläche des Lithographiefluids in das Lithographiebad eingestrahlt werden, bspw. über ein entsprechend angepasstes Luftobjektiv. Es ist auch möglich, dass der Schreibstrahl über ein in das Lithographiefluid eingetauchtes Immersionsobjektiv direkt in das Lithographiefluid eingestrahlt wird (sog. "dip-in" Technologie, vgl. z.B. DE 10 2011 012 484 A1).

US 5,922,364 A beschreibt ein System für die Stereolithographie zum Ablagern einer Schicht eines flüssigen Mediums entlang einer oberen Oberfläche eines Bades mit einem flüssigem Medium.

DE 44 14 775 A1 offenbart eine Vorrichtung zum Herstellen eines dreidimensionalen Objekts mittels Stereolithographie. Durch Einwirkung von elektromagnetischer Strahlung wird ein flüssiges Material verfestigt.

EP 1 769 901 A2 zeigt ein Herstellungssystem zum schnellen Herstellen von Prototypen.

Die Erfindung beschäftigt sich mit der Aufgabe, bei den vorstehend beschriebenen Lithographie-Techniken eine Zuverlässigkeit und Qualität der Strukturierung zu verbessern. Insbesondere sollen Strukturen mit großer Erstreckung entlang der optischen Achse mit hoher Präzision geschrieben werden können.

Diese Aufgabe wird durch ein Verfahren gemäß Anspruch 1 gelöst. Hierbei handelt es sich um ein Lithographie-Verfahren zum Erzeugen einer Zielstruktur in einem Volumen an Lithographiefluid bzw. in einem mit Lithographiefluid ausgefüllten Volumen.

Das Verfahren wird mit einer Lithographievorrichtung durchgeführt. Die Lithographievorrichtung umfasst einen Aufnahmeraum für das Lithographiefluid. Der Aufnahmeraum stellt insbesondere ein Aufnahmevolumen bereit, in welches Lithographiefluid einbringbar, insbesondere einfüllbar, ist. Der Aufnahmeraum kann durch einen Behälter der Lithographievorrichtung bereitgestellt sein (siehe unten). Es ist auch denkbar, dass es sich bei dem Aufnahmeraum um ein zwischen einem Substrat und einer Austrittsoptik (siehe unten) der Lithographievorrichtung bereitgestelltes Aufnahmevolumen handelt. Die Lithographievorrichtung umfasst außerdem eine Strahlungsquelle zur Aussendung eines Schreibstrahls. Insbesondere handelt es sich bei der Strahlungsquelle um eine Laserquelle zur Aussendung eines Laserstrahls (Schreiblaserstrahls). Die Lithographievorrichtung umfasst außerdem eine Strahlführungseinrichtung zur Definition eines Strahlengangs für den Schreibstrahl von der Strahlungsquelle zu dem Lithographiefluid. Die Strahlführungseinrichtung umfasst eine Austrittsoptik mit einer Austrittsoberfläche, durch welche der Schreibstrahl entlang einer optischen Achse austritt und insbesondere in Folge in das Lithographiefluid eingestrahlt wird. Beispielsweise kann die Austrittsoptik eine Austrittsapertur mit einem Austrittslinsenmittel umfassen. Dann kann eine dem Lithographiefluid zugewandte Außenfläche des Austrittslinsenmittels die Austrittsoberfläche bilden. Es ist auch denkbar, dass die Austrittsoptik ein strahlungsdurchlässiges Abschlussfenster aufweist und dass eine dem Lithographiefluid zugewandte Oberfläche dieses Abschlussfensters die Austrittsfläche bereitstellt. Wie nachfolgend noch im Detail erläutert, kann die Austrittsoptik insbesondere eine Fokussieroptik zur Fokussierung des Schreibstrahls in einem Fokusbereich umfassen, insbesondere durch diese gebildet sein. Die Fokussieroptik kann ihrerseits eine Austrittsapertur, insbesondere umfassend ein Austrittslinsenmittel, umfassen. Die Austrittsoberfläche kann dann durch eine dem Lithographiefluid zugewandte Oberfläche des Austrittslinsenmittels in der Austrittsapertur gebildet sein. Die Lithographievorrichtung ist derart ausgebildet, dass die Austrittsoptik und/oder der Aufnahmeraum bzw. ein den Aufnahmeraum bereitstellender Behälter entlang der optischen Achse verlagerbar sind, sodass eine Relativposition von Austrittsoptik und Aufnahmeraum veränderbar ist. Die Lithographievorrichtung ist insofern insbesondere derart ausgebildet, dass ein Fokusbereich des Schreibstrahls innerhalb des Lithographiefluids entlang der optischen Achse verlagerbar ist.

Die Lithographievorrichtung umfasst außerdem eine Füllhöhe-Einstelleinrichtung, welche dazu ausgebildet ist, eine Füllhöhe des Lithographiefluids in dem Aufnahmeraum derart zu verändern, dass der Abstand zwischen der Oberfläche des Lithographiefluids, also der Luft-Lithographiefluid-Grenzfläche, und der Austrittsoberfläche der Austrittsoptik einstellbar ist. Mit anderen Worten ist die Füllhöhe-Einstelleinrichtung dazu ausgebildet, durch Verändern der Füllhöhe des Lithographiefluids einen Abstand zwischen der Oberfläche des Lithographiefluids und der Austrittsoberfläche der Austrittsoptik einzustellen.

Die nachfolgend in Bezug auf die Lithographievorrichtung als solche beschriebenen Vorteile und Merkmale können auch zur Ausgestaltung der Lithographievorrichtung gemäß Anspruch 1 dienen. Zur Vermeidung von Wiederholungen wird daher auf die untenstehende Offenbarung hierzu verwiesen.

Gemäß dem vorgeschlagenen Verfahren wird zunächst ein Lithographiefluid in dem Aufnahmeraum bereitgestellt. Das Lithographiefluid ist insbesondere derart auf die Strahlungsquelle, insbesondere auf eine Wellenlänge und/oder Intensität der ausgesandten Strahlung, abgestimmt, dass eine Verfestigung des Lithographiefluids nur in einem Fokusbereich des Schreibstrahls, insbesondere unter Ausnutzung eines Multi-Photonen-Prozesses, erfolgt.

Zum Erzeugen bzw. Schreiben der Zielstruktur wird der Schreibstrahl in das Lithographiefluid eingestrahlt und, insbesondere unter Ausnutzung von Multi-Photonen-Absorption, das Lithographiefluid in einem Fokusbereich des Schreibstrahls lokal verfestigt. Im Konkreten kann in dem Fokusbereich des Schreibstrahls eine Belichtungsdosis derart in das Lithographiefluid eingestrahlt werden, dass das Lithographiefluid, vorzugsweise unter Ausnutzung von Multi-Photonen-Absorption, lokal verändert und somit ein Strukturbereich erzeugt bzw. geschrieben wird. Das Lithographiefluid wird insofern, insbesondere unter Ausnutzung von Multi-Photonen-Absorption, lokal strukturiert. Insbesondere wird das Lithographiefluid durch Einstrahlen der Belichtungsdosis des Laser-Schreibstrahls chemisch und/oder physikalisch verändert, beispielsweise ausgehärtet oder polymerisiert. Die Belichtungsdosis ist insbesondere eine Volumendosis an Strahlungsenergie.

Zum Erzeugen von dreidimensionalen Strukturen kann der Fokusbereich des Schreibstrahls eine Scan-Mannigfaltigkeit durch das Lithographiefluid durchlaufen. Die Scan-Mannigfaltigkeit kann im einfachen Fall eine Scan-Kurve sein, jedoch auch komplexer ausgeführt sein. Insofern kann der Fokusbereich des Schreibstrahls durch das Lithographiefluid verlagert werden. Zu diesem Zweck kann der Schreibstrahl innerhalb eines Schreibbereichs der Lithographievorrichtung mit der für die Zwecke der Strukturierung erforderlichen Präzision gesteuert werden, bspw. mittels einer Strahllenkungseinrichtung kontrolliert abgelenkt werden. Denkbar ist aber auch, dass das Lithographiefluid, bzw. ein das Lithographiefluid aufnehmender Behälter, mittels einer Positioniereinrichtung kontrolliert relativ zu dem Schreibstrahl verlagert wird.

Beide Konzepte zur Verlagerung können auch gemeinsam angewendet werden.

Gemäß dem vorgeschlagenen Verfahren wird die Füllhöhe des Lithographiefluids in dem Aufnahmeraum, insbesondere in Abhängigkeit einer Relativposition von Aufnahmeraum und Austrittsoptik, mittels der Füllhöhe-Einstelleinrichtung verändert.

Eine solche Ausgestaltung ermöglicht es, durch Verändern der Füllhöhe einen Abstand zwischen der Austrittsoberfläche der Austrittsoptik und der Oberfläche des Lithographiefluids auf einfache Weise bedarfsgerecht einzustellen. Insbesondere kann in Abhängigkeit einer Relativposition von Austrittsoptik und Aufnahmeraum eine Füllhöhe des Lithographiematerials derart nachgeregelt werden, dass ein Abstand zwischen der Austrittsoberfläche und der Oberfläche des Lithographiefluids konstant oder zumindest innerhalb eines Toleranzbereichs um einen Zielabstand gehalten werden kann (Details siehe unten). Auf diese Weise kann eine Schreibqualität verbessert werden, insbesondere bei Strukturen mit großer Erstreckung entlang der optischen Achse.

Beispielsweise kann die Austrittsoptik ein Luftobjektiv umfassen, welches die Austrittsfläche bereitstellt (siehe unten). Dann kann die Austrittsoberfläche beim Schreiben der Struktur außerhalb des Lithographiefluids angeordnet sein, sodass der Schreibstrahl von außen durch die Oberfläche des Lithographiefluids in dieses eingestrahlt wird. Der Abstand zwischen Austrittsoberfläche und Oberfläche des Lithographiefluids entspricht dann insbesondere einer Dicke des Luftspalts zwischen Austrittsoberfläche und Lithographiefluid. Bei einer solchen Anordnung kann es zu Aberrationseffekten aufgrund unterschiedlicher optischer Wege durch Bereiche mit unterschiedlichem Brechungsindex (Luftspalt bzw. Lithographiefluid) kommen, was insbesondere dann, wenn ein Abstand zwischen Austrittsfläche und Oberfläche des Lithographiefluids während des Schreibens verändert wird, zu lokalen Artefakten in der geschriebenen Struktur führen kann. Das vorgeschlagene Verfahren ermöglicht es nun, solche Artefakte zu reduzieren, indem durch Verändern einer Füllhöhe des Lithographiefluids ein Abstand zwischen Austrittsfläche und Oberfläche des Lithographiefluids auch bei Veränderung einer Relativposition von Aufnahmeraum und Austrittsfläche konstant gehalten werden kann. Darüber hinaus ermöglicht es das vorgeschlagene Verfahren, auch bei Verwendung von Luftobjektiven vergleichsweise hohe Strukturen mit hoher Präzision zu schreiben. Denn dadurch, dass die Füllhöhe mit einer Strukturhöhe anwachsen kann, ist eine maximal erzielbare Strukturhöhe nicht mehr durch den Arbeitsabstand des Luftobjektivs limitiert. Im Rahmen eines weiteren vorteilhaften Aspekts, kann der Abstand zwischen Austrittsfläche und Oberfläche des Lithographiefluids derart eingestellt werden, dass sich der Fokusbereich des Schreibstrahls beim Schreiben unmittelbar unter der Oberfläche des Lithographiefluids befindet, was das Strukturieren auch von stark absorbierenden Lithographiefluiden ermöglicht.

Die Austrittsoptik kann auch ein Immersionsobjektiv umfassen, welches die Austrittsoberfläche bereitgestellt. Dann kann die Austrittsoberfläche bei bestimmungsgemäßem Gebrauch in das Lithographiefluid eingetaucht sein ("Dip-in"). Der Abstand zwischen Austrittsoberfläche und Oberfläche des Lithographiefluids ist dann insbesondere ein Maß dafür, wie tief das Immersionsobjektiv in das Lithographiefluid eingetaucht ist. Bei solchen Ausgestaltungen kann dann durch Anpassen der Füllhöhe ein zu tiefes Eintauchen des Immersionsobjektiv in das Lithographiefluid vermieden werden und somit beispielsweise das Immersionsobjektiv teilweise vor Verschmutzungen geschützt werden. Es ist grundsätzlich auch denkbar, dass die Austrittsoptik ein Luftobjektiv umfasst, auf welches ein Immersionsaufsatz, bspw. in Form einer Kappe, aufgesetzt ist. Dann ist es denkbar, dass das Luftobjektiv mit dem Immersionsaufsatz in das Lithographiefluid eingetaucht ist. Es ist auch denkbar, dass die Austrittsoptik ein Immersionsobjektiv umfasst, auf welches ein Immersionsaufsatz, bspw. in Form einer Kappe, aufgesetzt ist, und dass zwischen Immersionsobjektiv und Immersionsaufsatz ein Immersionsmittel vorgesehen ist. Insbesondere kann der Immersionsaufsatz, bei Verwendung mit einem Luftobjektiv oder mit einem Immersionsobjektiv, ein strahldurchlässiges Austrittsfenster, bspw. eine Glasscheibe oder eine flexible Folie, umfassen, durch welches der Schreibstrahl austritt. Dann kann die Austrittfläche durch eine dem Lithographiefluid zugewandte Außenfläche des Austrittsfensters (z.B. Glasscheibe oder flexible Folie) bereitgestellt sein. Das Austrittsfenster bzw. die Austrittsfläche ist insofern für den Schreibstrahl, insbesondere für Laserlicht, transparent.

Im Rahmen der vorstehenden Überlegungen hat es sich als besonders vorteilhaft herausgestellt, wenn die Füllhöhe derart verändert wird, insbesondere Füllhöhe und Relativposition von Austrittsoberfläche und Oberfläche des Lithographiefluids derart aufeinander abgestimmt werden, dass während des Einstrahlens des Schreibstrahls in das Lithographiefluid zum Verfestigen des Lithographiefluids (also während des eigentlichen Schreibens der Zielstruktur bzw. während des Verfestigens des Lithographiefluids) der Abstand zwischen der Oberfläche des Lithographiefluids und der Austrittsoberfläche der Austrittsoptik stets innerhalb eines vorgegebenen oder vorgebbaren Toleranzbereichs um einen Zielabstand entlang der optischen Achse liegt. Mit anderen Worten wird die Füllhöhe vorzugsweise derart angepasst, dass der Abstand zwischen Oberfläche des Lithographiefluids und Austrittsoberfläche der Austrittsoptik einen ersten Schwellwert nicht unterschreitet und einen zweiten Schwellwert nicht überschreitet. Auf diese Weise lassen sich die vorstehend erwähnten Aberrationsartefakte reduzieren.

In diesem Zusammenhang hat es sich als vorteilhaft herausgestellt, wenn eine Breite des Toleranzbereichs zwischen 0,04 mm und 40 mm, insbesondere zwischen 0,21 mm und 18 mm, beträgt. Insbesondere ist eine Breite des Toleranzbereichs kleiner 10 mm, insbesondere kleiner 5 mm, weiter insbesondere kleiner 4 mm, weiter insbesondere kleiner 3 mm, weiter insbesondere kleiner 2 mm, weiter insbesondere kleiner 0,5 mm. Mit anderen Worten wird eine Füllhöhe insbesondere derart angepasst, dass der Abstand zwischen Oberfläche des Lithographiefluids und Austrittsoberfläche der Austrittsoptik während des eigentlichen Schreibens der Zielstruktur bzw. eines Strukturabschnitts der Zielstruktur um maximal 40 mm, insbesondere maximal 18 mm, weiter insbesondere maximal 10 mm, weiter insbesondere maximal 5 mm, weiter insbesondere maximal 4 mm, weiter insbesondere maximal 3mm, weiter insbesondere maximal 2 mm, verändert wird. Der Toleranzbereich kann insbesondere in Abhängigkeit einer numerischen Apertur und/oder eines Arbeitsabstands (Abstand Fokus zur Austrittsfläche) der Austrittsoptik, insbesondere Fokussieroptik, gewählt sein.

Besonders bevorzugt ist es jedoch, wenn die Füllhöhe derart angepasst wird, dass während des eigentlichen Schreibens der Zielstruktur der Abstand zwischen Oberfläche des Lithographiefluids und Austrittsoberfläche der Austrittsoptik im Wesentlichen konstant, vorzugsweise konstant, ist. Insofern bleiben möglicherweise auftretende Aberrationseffekte ebenfalls konstant, sodass es zu keinen lokal abweichenden Strukturartefakten kommt.

Zum Schreiben von entlang der optischen Achse erstreckten dreidimensionalen Strukturen wird insbesondere eine Relativposition von Austrittsoptik und Aufnahmeraum und somit eine Position eines Fokusbereichs des Schreibstrahls in dem Lithographiefluid entlang der optischen Achse verändert. Dies kann dadurch erfolgen, dass die Austrittsoptik und/oder der Aufnahmeraum bzw. ein diesen bereitstellender Behälter entlang der optischen Achse verlagert werden. In diesem Zusammenhang kann es vorteilhaft sein, wenn die Füllhöhe, insbesondere kontinuierlich, während einer Veränderung der Relativposition von Austrittsoptik und Aufnahmeraum verändert wird. Vorzugsweise wird die Füllhöhe derart verändert, dass ein Abstand zwischen der Oberfläche des Lithographiefluids und der Austrittsoberfläche der Austrittsoptik konstant bleibt.

Die Zielstruktur kann dadurch erzeugt werden, dass mehrere Teilstrukturen sequenziell erzeugt werden, welche gemeinsam die Zielstruktur annähern. Zu diesem Zweck kann die Zielstruktur bspw. rechnerisch in Teilstrukturen zerlegt werden und die Teilstrukturen jeweils durch eine vorzugsweise zusammenhängende Menge von Strukturbereichen (Voxel) geschrieben werden. Zum Schreiben von entlang der optischen Achse erstrecken Strukturen kann insbesondere eine erste Teilstruktur in einem ersten Teilvolumen des Aufnahmeraums erzeugt werden und im Anschluss eine zweite Teilstruktur in einem zweiten Teilvolumen des Aufnahmeraums, wobei das erste Teilvolumen und das zweite Teilvolumen entlang der optischen Achse versetzt sind, insbesondere entlang der optischen Achse übereinanderliegen. Insbesondere kann nach dem Erzeugen einer ersten Teilstruktur eine zweite Teilstruktur erzeugt werden, welche zu der ersten Teilstruktur, insbesondere entlang der optischen Achse versetzt ist. Dies schließt nicht aus, dass vor dem Schreiben der hier als erste Teilstruktur bezeichneten Teilstruktur und/oder nach dem Schreiben der hier als zweite Teilstruktur beschriebenen Teilstruktur weitere Teilstrukturen geschrieben werden.

Die Teilstrukturen weisen vorzugsweise eine gewisse Erstreckung entlang der optischen Achse auf. Insbesondere können die Teilstrukturen ihrerseits dadurch erzeugt werden, dass mehrere Strukturlagen sequentiell geschrieben werden.

Bei den vorstehend beschriebenen Ausgestaltungen mit Teilstrukturen kann die Füllhöhe des Lithographiefluids nach dem Erzeugen der ersten Teilstruktur und vor dem Schreiben der zweiten Teilstruktur um einen vorgegebenen Betrag, insbesondere diskret, erhöht oder erniedrigt werden. Dies meint nicht zwangsläufig, dass nach dem Erzeugen einer jeden Teilstruktur die Füllhöhe verändert wird. Es ist beispielsweise denkbar, dass mehrere Teilstrukturen sequentiell geschrieben werden, ohne dass die Füllhöhe durch die Füllhöhe-Einstelleinrichtung verändert wird, und nur nach dem Erzeugen ausgewählter Teilstrukturen (hier als "erste Teilstruktur" bezeichnet) die Füllhöhe verändert wird. Das Verändern der Füllhöhe kann vor oder nach Veränderung einer Relativposition von Austrittsoptik und Aufnahmeraum zum Schreiben der zweiten Teilstruktur erfolgen. In diesem Zusammenhang hat es sich als vorteilhaft herausgestellt, wenn die Füllhöhe um einen Betrag zwischen 0,04 mm und 40 mm, insbesondere zwischen 0,21 mm und 18 mm, weiter insbesondere zwischen 1 mm und 5 mm, weiter insbesondere zwischen 1 mm und 3 mm, erhöht oder erniedrigt wird. Insbesondere wird während des Schreibens einer jeweiligen Teilstruktur eine Füllhöhe durch die Füllhöhe-Einstelleinrichtung nicht verändert. Insofern kann es vorteilhaft sein, wenn die Teilstrukturen derart ausgebildet sind, dass zum Erzeugen einer jeweiligen Teilstruktur eine Relativposition von Aufnahmeraum und Austrittsoptik entlang der optischen Achse nur soweit verändert wird, dass bei konstanter Füllhöhe des Lithographiefluids der Abstand zwischen Oberfläche des Lithographiefluids und Austrittsoberfläche den vorstehend erwähnten Toleranzbereich nicht über- bzw. unterschreitet. Gemäß einem allgemeinen Aspekt kann der Schreibstrahl in dem Fokusbereich eine, insbesondere länglich erstrecke, Intensitätsverteilung aufweisen. Eine vorteilhafte Weiterbildung kann darin bestehen, dass die Füllhöhe derart eingestellt wird, dass während des Einstrahlens des Schreibstrahls in das Lithographiefluid zum Verfestigen des Lithographiefluids (also während des eigentlichen Schreibens) ein erster Teilbereich der Intensitätsverteilung des Schreibstrahls in dem Fokusbereich unterhalb der Oberfläche des Lithographiefluids angeordnet ist und ein zweiter Teilbereich der Intensitätsverteilung oberhalb der Oberfläche des Lithographiefluids, insbesondere in der Luft, angeordnet ist. Hierdurch kann eine Auflösung verbessert werden.

Es ist grundsätzlich denkbar, dass die Füllhöhe des Lithographiefluids in dem Aufnahmeraum dadurch verändert wird, dass das Volumen des Aufnahmeraums verändert wird. Beispielsweise ist es denkbar, dass der Aufnahmeraum durch einen Behälter bereitgestellt ist und zum Verändern der Füllhöhe ein Verdrängerkörper in ein im Behälter aufgenommenes Lithographiefluid eingetaucht wird (Anstieg der Füllhöhe) oder herausgezogen wird (Sinken der Füllhöhe). Alternativ oder zusätzlich ist es auch denkbar, dass ein von dem Behälter bereitgestellter Aufnahmeraum, bzw. ein Aufnahmevolumen, durch Verformung oder Verlagerung einer Behälterwandung des Behälters verändert, insbesondere verringert oder vergrößert, wird.

Vorzugsweise erfolgt eine Veränderung der Füllhöhe des Lithographiefluids in dem Aufnahmeraum jedoch dadurch, dass Lithographiefluid dem Aufnahmeraum zugeführt wird oder aus dem Aufnahmeraum abgeführt wird. Insofern kann die Füllhöhe-Einstelleinrichtung eine Fluidfördereinrichtung zum Zuführen und/oder Abführen von Lithographiefluid umfassen (siehe unten).

Die Füllhöhe-Einstelleinrichtung kann auch dazu verwendet werden, verschiedene Lithographiefluide nacheinander oder gleichzeitig dem Aufnahmeraum zuzuführen oder aus diesem abzuführen. Im Rahmen einer vorteilhaften Weiterbildung kann beispielsweise ein erstes Lithographiefluid in dem Aufnahmeraum bereitgestellt werden und durch Einstrahlen des Schreibstrahls lokal verfestigt werden und danach ein zweites, insbesondere von dem ersten Lithographiefluid verschiedenes, Lithographiefluid in dem Aufnahmeraum bereitgestellt werden und sodann durch Einstrahlen des Schreibstrahls lokal verfestigt werden. Dies ermöglicht es, verschiedene Bereiche der Zielstruktur, beispielsweise entsprechend einer zu erwartenden mechanischen Belastung, aus unterschiedlichen Materialien zu fertigen (Multimaterialdruck) .

Das Bereitstellen des ersten und des zweiten Lithographiefluids kann insbesondere durch Zuführen des jeweiligen Lithographiefluids in den Aufnahmeraum mittels der Füllhöhe-Einstelleinrichtung erfolgen. Um eine möglicherweise unerwünschte Mischung des ersten und des zweiten Lithographiefluids zu vermeiden, kann es vorteilhaft sein, wenn nach dem lokalen Verfestigen des ersten Lithographiefluids und vor dem Bereitstellen, insbesondere Zuführen, des zweiten Lithographiefluids zumindest eine Teilmenge des ersten Lithographiefluids, insbesondere im Wesentlichen das gesamte Volumen des ersten Lithographiefluids, mittels der Füllhöhe-Einstelleinrichtung aus dem Aufnahmeraum entfernt, insbesondere abgesaugt, wird. Zu diesem Zweck kann die Lithographievorrichtung eine Fluidfördereinrichtung umfassen, welche dazu ausgebildet ist, wenigstens zwei Lithographiefluide unabhängig voneinander dem Aufnahmeraum zuzuführen und wieder aus diesem abzuführen (siehe unten).

Im Rahmen einer vorteilhaften Weiterbildung ist es auch denkbar, dass nach dem lokalen Verfestigen des ersten Lithographiefluids und vor dem Bereitstellen des zweiten Lithographiefluids, insbesondere nach einem zumindest teilweisen Entfernen des ersten Lithographiematerials, ein Zwischenentwicklungsschritt durchgeführt wird, insbesondere ein Entwicklermedium in dem Aufnahmeraum bereitgestellt wird, vorzugsweise mittels der Füllhöhe-Einstelleinrichtung dem Aufnahmeraum zugeführt wird. Auf diese Weise kann die mit dem ersten Lithographiefluid geschriebene Struktur bspw. verfestigt werden.

Bei der vorliegend angewandten Art des 3D-Schreibens kann es besonders vorteilhaft sein, wenn das Einbringen der Belichtungsdosis mittels Multi-Photonen-Absorption erfolgt. Hierzu ist das Lithographiefluid vorzugsweise derart ausgebildet und der Schreibstrahl, insbesondere Schreiblaserstrahl, derart auf das Lithographiefluid abgestimmt, dass eine Veränderung des Lithographiefluids (z.B. lokale Polymerisation) nur mittels Absorption mehrerer Photonen möglich ist. Hierzu kann beispielsweise die Wellenlänge des Schreibstrahls derart gewählt (und damit die zugeordnete Quantenenergie derart bemessen sein), dass der für die Veränderung des Lithographiefluids erforderliche Energieeintrag nur durch gleichzeitige Absorption zweier oder mehrerer Quanten erreicht wird. Die Wahrscheinlichkeit für einen solchen Prozess ist nichtlinear intensitätsabhängig und im Fokusbereich gegenüber dem übrigen Schreibstrahl deutlich erhöht. Aus grundsätzlichen Überlegungen ergibt sich, dass die Wahrscheinlichkeit zur Absorption von zwei oder mehr Quanten vom Quadrat oder einer höheren Potenz der Strahlungsintensität abhängen kann. Der Mechanismus der Multi-Photonen-Absorption ermöglicht es daher, auch im Inneren eines Volumens aus Lithographiefluid, also auch vergleichsweise tief unter der Oberfläche des Lithographiefluids, die gewünschte Belichtungsdosis einzubringen und das Lithographiefluid lokal zu verändern.

Als Lithographiefluid werden im vorliegenden Zusammenhang grundsätzlich solche Substanzen bezeichnet, deren chemische und/oder physikalische Materialeigenschaften durch die Bestrahlung mit einem Schreibstrahl veränderbar sind, bspw. sogenannte Lithographielacke. Je nach Art der durch den Schreibstrahl induzierten Veränderungen können Lithographiematerialien in sogenannte Negativlacke (bei welchem durch Bestrahlung eine lokale Aushärtung erfolgt oder die Löslichkeit in einem Entwicklermedium verringert wird) und in sogenannte Positivlacke (bei welchem durch die Bestrahlung lokal die Löslichkeit in einem Entwicklermedium erhöht wird) unterschieden werden.

Die eingangs genannte Aufgabe wird auch durch eine Lithographievorrichtung gemäß Anspruch 10 gelöst. Die Lithographievorrichtung ist dazu ausgebildet, eine dreidimensionale Zielstruktur in einem Lithographiefluid, insbesondere durch einen Multi-Photonen-Prozess, zu erzeugen. Die Lithographievorrichtung ist vorzugsweise dazu ausgebildet und angepasst, das vorstehend beschriebene Verfahren durchzuführen. Insofern können die in Bezug auf das Verfahren erläuterten Vorteile und Merkmale der Lithographievorrichtung auch zur Ausgestaltung der Lithographievorrichtung gemäß Anspruch 10 dienen.

Die Lithographievorrichtung umfasst einen Aufnahmeraum für das Lithographiefluid. Der Aufnahmeraum kann insbesondere durch einen Behälter bereitgestellt sein. Der Behälter kann vorzugsweise zumindest einseitig offen sein. Die Lithographievorrichtung umfasst außerdem eine Strahlungsquelle zur Aussendung eines Schreibstrahls. Vorzugsweise handelt es sich bei der Strahlungsquelle um eine Laserquelle zur Aussendung eines Laserstrahls (Schreiblaserstrahls). Darüber hinaus umfasst die Lithographievorrichtung eine Strahlführungseinrichtung zur Definition eines Strahlengangs für den Schreibstrahl von der Strahlungsquelle zu dem Lithographiefluid. Die Strahlführungseinrichtung umfasst eine Austrittsoptik mit einer Austrittsoberfläche, durch welche der Schreibstrahl entlang einer optischen Achse austritt. Wie vorstehend in Bezug auf das Verfahren bereits erwähnt, kann die Austrittsoptik eine Austrittsapertur mit einem Austrittslinsenmittel umfassen. Dann kann eine dem Lithographiefluid zugewandte Außenfläche des Austrittslinsenmittels die Austrittsoberfläche bilden. Es ist auch denkbar, dass die Austrittsoptik ein strahlungsdurchlässiges Abschlussfenster aufweist, wobei eine dem Lithographiefluid zugewandte Oberfläche dieses Abschlussfensters die Austrittsfläche bildet. Wie nachfolgend noch im Detail erläutert, kann die Austrittsoptik insbesondere eine Fokussieroptik zur Fokussierung des Schreibstrahls in einem Fokusbereich umfassen. Die Lithographievorrichtung ist derart ausgebildet, dass die Austrittsoptik und/oder der Aufnahmeraum entlang der optischen Achse verlagerbar sind, was ein Schreiben von entlang der optischen Achse ausgedehnten dreidimensionalen Strukturen ermöglicht. Insofern ist die Lithographievorrichtung insbesondere derart ausgebildet, dass eine Relativposition von Austrittsoptik und Aufnahmeraum veränderbar ist. Zu diesem Zweck kann die Lithographievorrichtung eine Verlagerungseinrichtung zur Verlagerung der Austrittsoptik bzw. Fokussieroptik entlang der optischen Achse umfassen. Alternativ oder zusätzlich kann die Lithographievorrichtung eine Positioniereinrichtung zur Verlagerung des Aufnahmeraums, insbesondere eines den Aufnahmeraum bereitstellenden Behälters, umfassen. Die Lithographievorrichtung umfasst außerdem eine Füllhöhe-Einstelleinrichtung, welche dazu ausgebildet ist, eine Füllhöhe des Lithographiefluids in dem Aufnahmeraum zu verändern, um so eine einen Abstand zwischen der Oberfläche des Lithographiefluids und der Austrittsoberfläche der Austrittsoptik einzustellen.

Zur Vermeidung von Wiederholungen wird hinsichtlich der Vorteile einer solchen Lithographievorrichtung mit Füllhöhe-Einstelleinrichtung auf die vorstehende Beschreibung in Bezug auf das vorgeschlagene Verfahren verwiesen.

Die Füllhöhe-Einstelleinrichtung ist vorzugsweise dazu eingerichtet, die Füllhöhe des Lithographiefluids in dem Aufnahmeraum zu verringern und/oder zu erhöhen, insbesondere in Abhängigkeit einer Relativposition von Aufnahmeraum und Austrittsoptik.

Vorzugsweise ist die Füllhöhe-Einstelleinrichtung dazu ausgebildet, eine Füllhöhe durch Zuführen und/oder Abführen von Lithographiefluid in dem Aufnahmeraum zu verändern. Insofern kann die Füllhöhe-Einstelleinrichtung eine Fluidfördereinrichtung zum Fördern von Lithographiefluid umfassen. Die Fluidfördereinrichtung kann insbesondere dazu ausgebildet sein, Lithographiefluid dem Aufnahmebereich zuzuführen und/oder aus dem Aufnahmebereich abzuführen, um so eine Füllhöhe des Lithographiefluids in dem Aufnahmeraum zu verändern. Die Fluidfördereinrichtung kann insbesondere dazu eingerichtet sein, zum Verringern einer Füllhöhe Lithographiefluid aus dem Aufnahmeraum abzusaugen. Dies ermöglicht es z.B. die Belichtung einer Struktur wieder an einer in Einstrahlrichtung betrachtet "tieferen" Position im Lithographiematerial fortzuführen, die sonst nicht mehr durch den Arbeitsabstand der Austrittsoptik, insbesondere Fokussieroptik, erreicht werden könnte.

Im Konkreten kann die Fluidfördereinrichtung wenigstens eine Fluidleitung und wenigstens eine Pumpeneinrichtung, insbesondere Pumpe, umfassen. Die wenigstens eine Fluidleitung und die wenigstens eine Pumpeneinrichtung sind insbesondere zum Zuführen von Lithographiefluid in den Aufnahmeraum und/oder zum Absaugen von Lithographiefluid aus dem Aufnahmeraum ausgebildet.

Die Füllhöhe-Einstelleinrichtung, insbesondere die Fluidfördereinrichtung, kann außerdem wenigstens ein Lithographiefluid-Reservoir bzw. Lithographiefluid-Tank umfassen. Das Lithographiefluid-Reservoir kann als Fluid-Zwischenspeicher dienen, um aus dem Aufnahmeraum abgeführtes Lithographiefluid zwischenzuspeichern.

Es ist möglich, dass das Lithographiefluid durch dieselbe Fluidleitung dem Aufnahmeraum zugeführt und aus diesem abgesaugt wird. Es ist auch möglich, dass die Fluidfördereinrichtung wenigstens eine Fluidzuführleitung zum Zuführen von Lithographiefluid in den Aufnahmeraum und wenigstens eine hiervon separate Fluidabführleitung zum Abführen von Lithographiefluid aus dem Aufnahmeraum umfasst.

Im Rahmen einer vorteilhaften Weiterbildung können wenigstens eine Fluidzuführleitung und wenigstens eine Fluidabführleitung mit einem vorstehend bereits erwähnten Lithographiefluid-Reservoir fluidisch verbunden sein, insbesondere derart, dass die wenigstens eine Fluidzuführleitung und die wenigstens eine Fluidrückführleitung zusammen mit dem Aufnahmeraum und dem Lithographiefluid-Reservoir einen Fluidkreislauf bilden. Dies ermöglicht es, Lithographiefluid zu recyceln, insbesondere Lithographiefluid zunächst aus dem Aufnahmeraum abzuführen und dann später dem Aufnahmeraum wieder zuzuführen. Insbesondere kann eine Pumpeneinrichtung zum Fördern des Lithographiefluids innerhalb des Fluidkreislaufs vorgesehen sein.

Im Rahmen einer vorteilhaften Weiterbildung kann die Füllhöhe-Einstelleinrichtung eine Mehrzahl von Fluidzuführleitungen und eine Mehrzahl von Fluidrückführleitungen aufweisen. Insbesondere kann ein erstes Paar bestehend aus einer Fluidzuführleitung und einer Fluidrückführleitung zum Zuführen bzw. Abführen eines ersten Lithographiefluids ausgebildet sein und ein zweites Paar bestehend aus einer Fluidzuführleitung und einer Fluidrückführleitung zum Zuführen bzw. Abführen eines zweiten Lithographiefluids ausgebildet sein. Das erste Paar kann mit einem ersten Lithographiefluid-Reservoir verbunden sein, vorzugsweise einen ersten Fluidkreislauf bilden, und das zweite Paar kann mit einem zweiten Lithographiefluid-Reservoir verbunden sein, vorzugsweise einen zweiten Fluidkreislauf bilden. Eine solche Ausgestaltung erleichtert einen vorstehend erwähnten Multimaterialdruck, da die verschiedenen Lithographiefluide separat dem Aufnahmeraum zugeführt bzw. aus diesem abgeführt werden können.

Vorzugsweise ist der Aufnahmeraum durch einen Behälter bereitgestellt. Der Behälter umfasst insbesondere eine Behälterwandung, welche den Aufnahmeraum begrenzt. Der Behälter kann wenigstens einen Fluidanschluss zum Zuführen und/oder Abführen von Lithographiefluid in bzw. aus dem Aufnahmeraum aufweisen. Die Fluidanschlüsse können dann mit entsprechenden Fluidleitungen der Fluidfördereinrichtung verbunden sein. Im einfachsten Fall können die Fluidanschlüsse durch lokale Aussparungen in einer Behälterwandung bereitgestellt sein. Es ist aber auch möglich, dass der Behälter durch eine Hauptöffnung einseitig offen ist (bspw. in Form einer Schale) und dass die wenigstens eine Fluidleitung der Fluidfördereinrichtung (bspw. in Form eines Schlauchs) durch die Hauptöffnung des Behälters in den Aufnahmeraum eingeführt ist. Die Fluidleitung kann auch über eine entsprechende Haltevorrichtung an dem Behälter gehaltert sein. Beispielsweise ist es denkbar, dass die Fluidleitung an einer Behälterinnenwandung gehaltert ist oder in den Behälter eingelegt ist.

Es ist möglich, dass der Behälter nur einen Fluidanschluss aufweist, durch den Lithographiefluid dem Aufnahmeraum sowohl zugeführt als auch aus diesem abgeführt werden kann. Es ist auch möglich, dass der Behälter wenigstens einen Fluidzuführanschluss zum Zuführen von Lithographiefluid und wenigstens einen von dem Fluidzuführanschluss separaten Fluidabführanschluss zum Abführen von Lithographiefluid aufweist.

Wie eingangs bereits erwähnt, umfasst die Strahlführungseinrichtung insbesondere eine Fokussieroptik zur Fokussierung des Schreibstrahls in einem Fokusbereich. Im Rahmen einer vorteilhaften Ausgestaltung, kann die Fokussieroptik ein Luftobjektiv umfassen. Solche Luftobjektive weisen insbesondere eine numerische Apparatur zwischen 0,025 und 1,0 auf. Insbesondere stellt das Luftobjektiv die Austrittsoberfläche bereit. Beispielsweise kann das Luftobjektiv eine Austrittsapertur mit einem Austrittslinsenmittel aufweisen, wobei eine dem Lithographiefluid zugewandte Außenfläche des Austrittslinsenmittels die Austrittsoberfläche bereitgestellt. Das Luftobjektiv ist vorzugweise derart angeordnet, dass die Austrittsoberfläche von dem Lithographiefluid beabstandet angeordnet ist, also insbesondere außerhalb des Lithographiefluids angeordnet ist. Insofern ist ein Luftspalt zwischen Austrittsoberfläche und Oberfläche des Lithographiefluids gebildet, dessen Dicke den vorstehend beschriebenen Abstand definiert. Die mit den Luftobjektiven einhergehende kleine numerische Apertur ermöglicht es, auch vergleichsweise große Strukturen schnell zu schreiben, was insbesondere bei automatisierten Prozessen im industriellen Maßstab vorteilhaft sein kann.

Im Rahmen einer alternativen vorteilhaften Ausgestaltung kann die Fokussieroptik ein Immersionsobjektiv umfassen, insbesondere dadurch gebildet sein. Dann kann die Austrittsoberfläche durch das Immersionsobjektiv bereitgestellt sein, bspw. durch eine dem Lithographiefluid zugewandte Außenfläche eines Austrittslinsenmittels einer Austrittsapertur des Immersionsobjektivs. Zum Schreiben der Zielstruktur kann das Immersionsobjektiv dann in das Lithographiefluid eingetaucht sein, sodass die Austrittsoberfläche unterhalb einer Oberfläche des Lithographiefluids angeordnet ist (sog. "dip-in"). Bei einer solchen Ausgestaltung ist der vorstehend beschriebene Abstand zwischen der Austrittsoberfläche der Austrittsoptik und der Oberfläche des Lithographiefluids insofern ein Maß dafür, wie weit die Austrittsoberfläche und somit das Immersionsobjektiv in das Lithographiefluid eingetaucht sind.

Wie vorstehend erwähnt, ist es grundsätzlich auch denkbar, dass die Fokussieroptik ein Luftobjektiv oder ein Immersionsobjektiv umfasst, auf welches ein Immersionsaufsatz, bspw. in Form einer Kappe, aufgesetzt ist. Dann ist es denkbar, dass das Luftobjektiv bzw. das Immersionsobjektiv mit dem Immersionsaufsatz in das Lithographiefluid eingetaucht ist. Bei Verwendung eines Immersionsobjektivs kann zwischen Immersionsobjektiv und Immersionsaufsatz ein Immersionsmittel vorgesehen sein. Insbesondere kann der Immersionsaufsatz ein strahldurchlässiges Austrittsfenster, bspw. eine Glasscheibe oder eine flexible Folie, umfassen, durch welches der Schreibstrahl austritt. Dann kann die Austrittfläche durch eine dem Lithographiefluid zugewandte Außenfläche des Austrittsfensters bereitgestellt sein. Das Austrittsfenster ist insofern transparent für den Schreibstrahl, insbesondere Laserstrahl.

Vorzugsweise umfasst die Lithographievorrichtung außerdem eine Sensoreinrichtung zur Erfassung, insbesondere Überwachung, einer Füllhöhe des Lithographiefluids in dem Aufnahmeraum. Dies ermöglicht es, die Füllhöhe präzise zu regeln. Insbesondere kann die Sensoreinrichtung mit der Füllhöhe-Einstelleinrichtung zusammenwirken. Die Sensoreinrichtung kann bspw. einen oder mehrere optische, mechanische oder elektrische Sensoren umfassen.

In vorteilhafter Weise kann die Lithographievorrichtung außerdem eine Steuereinrichtung zur Ansteuerung der Lithographievorrichtung umfassen. Die Steuervorrichtung kann insbesondere mit der Füllhöhe-Einstelleinrichtung und/oder der Sensoreinrichtung zusammenwirken, insbesondere diese ansteuern. Vorzugsweise kann die Steuereinrichtung dazu eingerichtet sein, das vorstehend beschriebene Verfahren durchzuführen. Insbesondere kann die Steuereinrichtung dazu eingerichtet sein, die Füllhöhe-Einstelleinrichtung derart anzusteuern, dass diese eine Füllhöhe des Lithographiefluids in dem Aufnahmeraum, insbesondere in Abhängigkeit einer Relativposition von Austrittsoptik und Aufnahmeraum und/oder einer von der Sensoreinrichtung erfassten Füllhöhe des Lithographiefluids in dem Aufnahmeraum, verändert, insbesondere derart, dass während des Einstrahlens des Schreibstrahls in das Lithographiefluid zum Verfestigen des Lithographiefluids (also während des eigentlichen Schreibens der Zielstruktur) ein Abstand zwischen der Austrittsoberfläche der Oberfläche des Lithographiefluids innerhalb eines vorgegebenen oder vorgebbaren Toleranzbereichs um einen Zielabstand entlang der optischen Achse liegt, insbesondere konstant ist.

Die Erfindung wird im Folgenden anhand der Figuren näher erläutert. Es zeigen:
- Fig. 1: vereinfachte schematische Darstellung einer Ausgestaltung einer Lithographievorrichtung;
- Fig. 2a-c: vereinfachte schematische Darstellungen zur Erläuterung eines Schreibvorgangs mittels der Lithographievorrichtung;
- Fig. 3a-b: vereinfachte schematische Darstellungen zur Erläuterung des Schreibens einer Teilstruktur;
- Fig. 4: vereinfachte schematische Darstellung zur Erläuterung einer Ausgestaltung der Füllhöhe-Einstelleinrichtung;
- Fig. 5: vereinfachte schematische Darstellung einer Ausgestaltung des Behälters für das Lithographiefluid; und
- Fig. 6: vereinfachte schematische Darstellungen zur Erläuterung eines Schreibvorgangs mittels Immersionsobjektiv.

In der nachfolgenden Beschreibung sowie in den Figuren sind für identische oder einander entsprechende Merkmale jeweils dieselben Bezugszeichen verwendet.

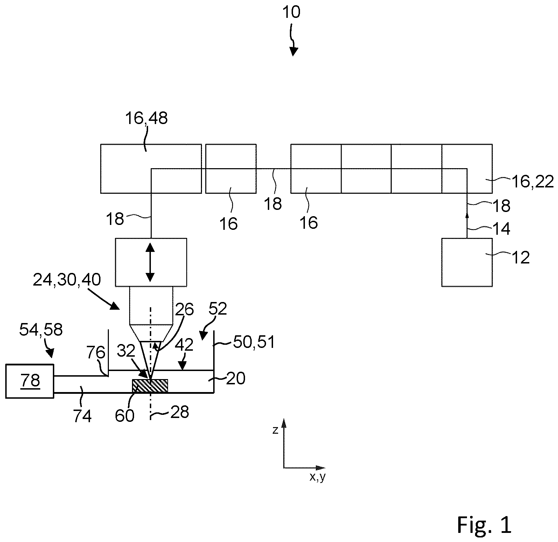

Die Fig. 1 zeigt in schematischer Darstellung eine Ausgestaltung einer Lithographievorrichtung, welche insgesamt mit dem Bezugszeichen 10 bezeichnet ist. Die Lithographievorrichtung 10 umfasst eine Strahlungsquelle 12, insbesondere Laserquelle, zur Aussendung eines Schreibstrahls 14, insbesondere Schreiblaserstrahls. Die Lithographievorrichtung 10 umfasst außerdem eine insgesamt mit dem Bezugszeichen 16 bezeichnete Strahlführungseinrichtung zur Definition eines Strahlengangs 18 für den Schreibstrahl 14 von der Strahlungsquelle 12 zu einem zu strukturierenden Lithographiematerial 20.

Die Strahlführungseinrichtung 16 weist in dem dargestellten Beispiel mehrere Module auf, welche optische und/oder mechanische Funktionen erfüllen. Beispielsweise kann der Strahlengang 18 zunächst durch eine Strahlformungseinrichtung 22 verlaufen.

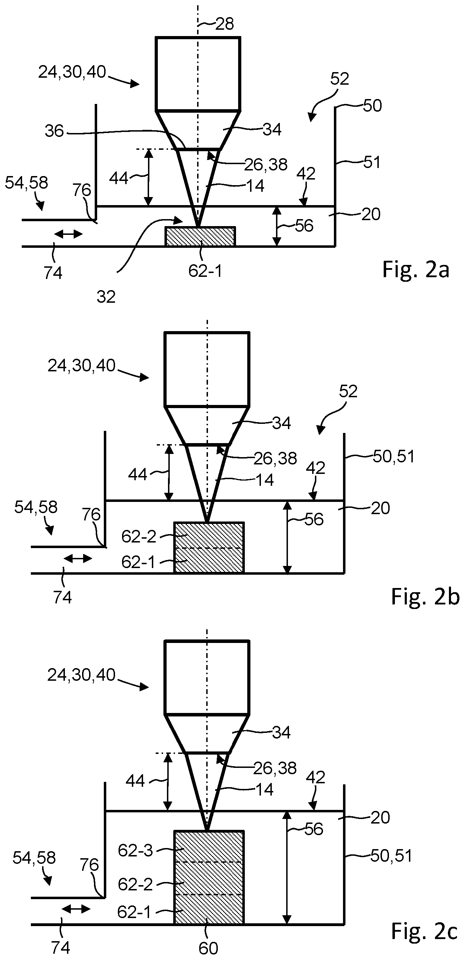

Die Strahlführungseinrichtung 16 umfasst außerdem eine Austrittsoptik 24 mit einer Austrittsoberfläche 26, durch welche der Schreibstrahl 14 entlang einer optischen Achse 28 (in Fig. 1 entlang der z-Achse des dort gezeigten Koordinatensystems) aus der Strahlführungseinrichtung 16 austritt (vgl. auch Fig. 2a). Die Austrittsoptik 24 umfasst vorzugsweise eine Fokussieroptik 30 zur Fokussierung des Schreibstrahls 14 in einem Fokusbereich 32. Im Konkreten kann die Fokussieroptik 30 eine Austrittsapertur 34 mit einem Austrittslinsenmittel 36 umfassen (vgl. Fig. 2a). Dann kann die Austrittsfläche 26 durch eine dem Lithographiefluid 20 zugewandte Außenfläche 38 des Austrittslinsenmittels 36 bereitgestellt sein.

Bei der in den Fig. 1 und 2 dargestellten Ausgestaltung ist die Fokussieroptik 30 als Luftobjektiv 40 ausgebildet, welches von dem Lithographiefluid 20 beabstandet angeordnet ist. Der Schreibstrahl 14 durchläuft somit nach Austritt aus der Austrittsoptik 24 zunächst einen Luftspalt und wird dann durch eine Oberfläche 42 des Lithographiefluids 20 in das Lithographiefluid 20 eingestrahlt. Ein Abstand zwischen der Austrittsoberfläche 26 und der Oberfläche 42 des Lithographiefluids 20 ist in den Figuren mit dem Bezugszeichen 44 bezeichnet.

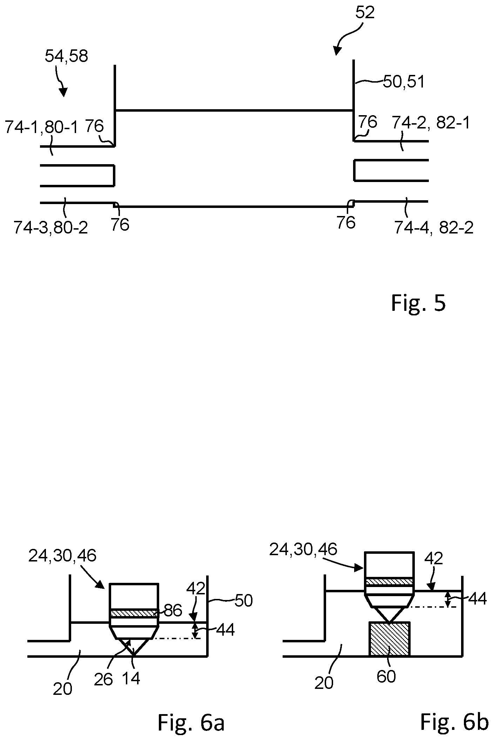

Bei weiteren Ausgestaltungen ist es auch möglich, dass die Fokussieroptik 30 als Immersionsobjektiv 46 ausgebildet ist und dieses zum Schreiben einer Struktur in das Lithographiefluid 20 eingetaucht ist (nachfolgend in Bezug auf Fig. 6 noch näher beschrieben). Bei nicht dargestellten Ausgestaltungen ist es auch denkbar, dass die Fokussieroptik ein Luftobjektiv umfasst, auf welches ein Immersionsaufsatz, bspw. in Form einer Kappe, aufgesetzt ist, und dass das Luftobjektiv mit dem Immersionsaufsatz zum Schreiben einer Struktur in das Lithographiefluid 20 eingetaucht ist.

Die Lithographievorrichtung 10 umfasst vorzugsweise außerdem eine Verlagerungseinrichtung (nicht dargestellt) zur Verlagerung der Fokussieroptik 24 entlang der optischen Achse 28. Die Strahlführungseinrichtung 16 kann außerdem eine Scan-Einrichtung 48 umfassen, mittels derer der Fokusbereich 32 des Schreibstrahls 14 innerhalb des Lithographiefluids 20 mit einer zur Strukturierung erforderlichen Präzision verlagert werden kann. Beispielsweise kann die Scan-Einrichtung 48 ein Strahllenkungsmodul umfassen, welches beispielsweise eine Galvanometer-Scanner-Einheit zur kontrollierten Auslenkung des Schreibstrahls 14 umfassen kann.

Wie in Fig. 1 skizziert dargestellt, umfasst die Lithographievorrichtung 10 einen Behälter 50 mit einer Behälterwandung 51, welche einen Aufnahmeraum 52 zur Aufnahme des Lithographiefluids 20 begrenzt. Der Behälter 50 kann ortsfest angeordnet sein. Der Behälter 50 kann auch mittels einer optionalen Positioniereinrichtung (nicht dargestellt) relativ zu dem Fokusbereich 32 des Schreibstrahls 14 positionsgenau verlagerbar sein, insbesondere entlang der optischen Achse 28. Die Positioniereinrichtung kann vorzugsweise dazu ausgebildet sein, den Behälter in allen drei Raumrichtungen x, y, z zu verlagern, optional zusätzlich auch um eine zu der x-Achse parallele erste Neigungsachse und/oder um eine zu der y-Achse parallele zweite Neigungsachse zu verkippen.

Die Lithographievorrichtung 10 umfasst außerdem eine nachfolgend noch im Detail beschriebene Füllhöhe-Einstelleinrichtung 54 zur Veränderung einer Füllhöhe 56 des Lithographiefluids 20 in dem Behälter 50. Im Beispiel umfasst die Füllhöhe-Einstelleinrichtung 54 eine Fluidfördereinrichtung 58 zum Zu- und Abführen von Lithographiefluid 20 in den Behälter 50 (Details siehe unten).

Die Lithographievorrichtung 10 umfasst vorzugsweise außerdem eine Steuereinrichtung (nicht dargestellt) zur Ansteuerung der Lithographievorrichtung 10. Die Steuereinrichtung umfasst vorzugsweise eine Recheneinheit und einen nichtflüchtigen Speicher.

Eine vorteilhafte Ausgestaltung eines Verfahrens zum Erzeugen einer Zielstruktur 60 mittels der vorstehend beschriebenen Lithographievorrichtung 10 wird im Folgenden anhand der Figuren 2a bis 2c erläutert.

Bei der beschriebenen Lithographievorrichtung 10 wird eine Zielstruktur 60 grundsätzlich dadurch definiert, dass der Fokusbereich 32 des Schreibstrahls 14 durch das Volumen an Lithographiefluid 20 (umgebend die gesamte Struktur) verlagert wird, insbesondere mittels der Scan-Einrichtung 48 und/oder durch Verlagerung der Fokussieroptik 30 und/oder des Behälters 50. In dem Fokusbereich 32 des Schreibstrahls 14 wird dabei lokal eine Schreib-Belichtungsdosis in das Lithographiefluid 20 eingestrahlt, sodass lokal, insbesondere unter Ausnutzung von Multi-Photonen-Absorption, Strukturbereiche definiert werden, welche gemeinsam die Zielstruktur 60 annähern.

Die Figuren 2a bis 2c zeigen beispielhaft verschiedene Stadien eines Schreibprozesses zum Schreiben einer entlang der optischen Achse 28 erstreckten Zielstruktur 60. Wie bei einem Vergleich der Figuren 2a bis 2c ersichtlich, wird der Fokusbereich 32 zum Schreiben einer solchen Struktur 60 entlang der optischen Achse 28 relativ zu dem Lithographiefluid 20 verfahren, sodass nacheinander Strukturbereiche entlang der optischen Achse 28 lokal verfestigt werden, welche in ihrer Gesamtheit dann die Zielstruktur 60 bilden. Insbesondere ist es denkbar, dass die Zielstruktur 60 aus einer Mehrzahl von Teilstrukturen 62-1, 62-2, 62-3 zusammengesetzt ist (in Fig. 2 beispielhaft durch Strichlinien angedeutet), welche entlang der optischen Achse 28 aufeinandergesetzt sind und selbst eine gewisse Erstreckung entlang der optischen Achse 28 aufweisen.

Die Verlagerung des Fokusbereichs 32 entlang der optischen Achse 28 erfolgt vorzugsweise dadurch, dass die Fokussieroptik 30, bspw. mittels der erwähnten Verlagerungseinrichtung, und/oder der Behälter 50, bspw. mittels der erwähnten Positioniereinrichtung, entlang der optischen Achse 28 relativ zueinander verlagert werden.

Gemäß dem vorgeschlagenen Verfahren wird die Füllhöhe 56 des Lithographiefluids 20 in dem Behälter 50 in Abhängigkeit einer Relativposition von Fokussieroptik 30 und Behälter 50 derart angepasst, dass der Abstand 44 zwischen der Austrittsoberfläche 26 der Fokussieroptik 30 und der Oberfläche 42 des Lithographiefluids 20 konstant ist oder zumindest einen vorgegebenen Toleranzbereich (nachfolgend noch im Detail erläutert) nicht über- oder unterschreitet. Im Beispiel gemäß Fig. 2a bis 2c wird insofern mit anwachsender Höhe der Struktur 60 die Füllhöhe 56 bzw. Füllstand des Lithographiefluids 20 in dem Behälter 50 erhöht.

Zu diesem Zweck wird mittels der Füllhöhe-Einstelleinrichtung 54 bzw. der Fluidfördereinrichtung 58 Lithographiefluid 20 dem Aufnahmeraum 52 zugeführt. Dies kann kontinuierlich bei einer Veränderung der Relativposition von Fokussieroptik 30 und Behälter 50 entlang der optischen Achse 28 erfolgen, insbesondere derart, dass der Abstand 44 stets konstant bleibt.

Es ist auch möglich, dass die Füllhöhe 56 in diskreten Schritten verändert wird. Beispielsweise ist es möglich, dass die Zielstruktur 60 aus mehreren Teilstrukturen 62-1, 62-2, 62-3 zusammengesetzt wird und die Füllhöhe 56 nach dem Schreiben einer ersten Teilstruktur 62-1 und vor dem Schreiben der nächsten Teilstruktur 62-2 um einen vorbestimmten Betrag 64 erhöht bzw. erniedrigt wird.

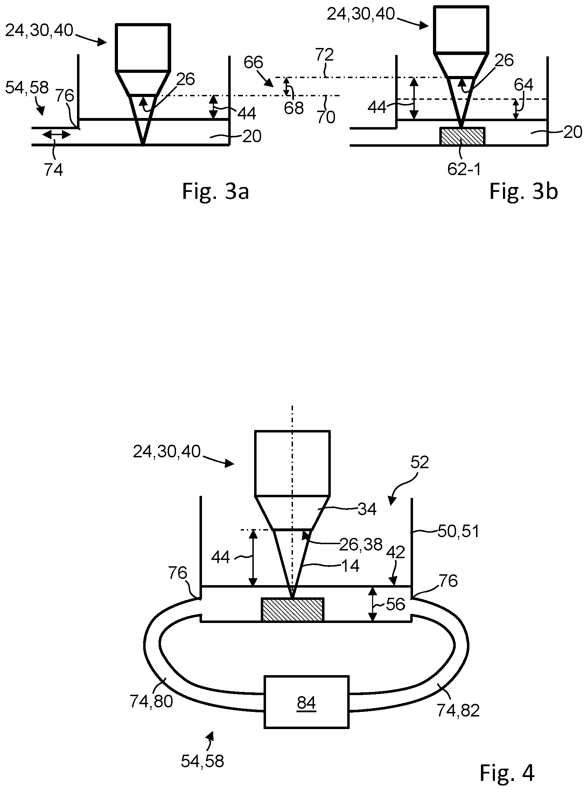

Bei einer solchen Ausgestaltung ist es dann denkbar, dass die Füllhöhe 44 während des Schreibens einer jeweiligen Teilstruktur 62-1, 62-1, 62-3 durch die Füllhöhe-Einstelleinrichtung 54 nicht verändert wird, also insbesondere kein Lithographiefluid 20 dem Aufnahmeraum 52 aktiv zugeführt oder aus diesem abgeführt wird. Insofern kann sich während des Schreibens einer jeweiligen Teilstruktur 62-1, 62-2, 62-3 der Abstand 44 zwischen Austrittsoberfläche 26 und Oberfläche 42 des Lithographiefluids 20 verändern, insbesondere wenn die Teilstrukturen 62-1, 62-2, 62-2 ihrerseits eine gewisse Erstreckung entlang der optischen Achse 28 aufweisen, bspw. aus mehreren übereinanderliegenden Schichten gebildet sind (vgl. Figuren 3a und 3b). Die Teilstrukturen 62-1, 62-2, 62-3 sind dann vorzugsweise so gewählt, dass der Abstand 44 beim Schreiben der Teilstruktur 62-1, 62-2, 62-3 nicht über einen vorgegebenen Toleranzbereich 66 hinaus verändert wird, innerhalb dessen eine Abstandsänderung akzeptabel ist (siehe oben, in den Fig. 3a und 3b schematisch dargestellt).

Insbesondere kann der Betrag 64, um den die Füllhöhe 56 erhöht oder erniedrigt wird, einer Breite 68 des Toleranzbereichs 66 entsprechen, also einer maximal zulässigen Veränderung des Abstands 44. Insofern wird sichergestellt, dass der Abstand 44 während des Schreibens der Zielstruktur 60 einen ersten Schwellwert 70 nicht unterschreitet und einen zweiten Schwellwert 72 nicht überschreitet (vgl. Fig. 3a und 3b, welche exemplarisch für die erste Teilstruktur 62-1 die beiden Extremlagen zeigen).

Die Fluidfördereinrichtung 58 umfasst in den Beispielen gemäß Fig. 1 bis 3 jeweils eine Fluidleitung 74, welche beispielhaft über einen entsprechenden Fluidanschluss 76 (in den Figuren vereinfacht als Öffnung in der Behälterwandung 51 dargestellt) in dem Behälter 50 in den Aufnahmeraum 52 einmündet. Wie vorstehend erwähnt, ist es bei nicht dargestellten Ausgestaltungen auch möglich, dass die Fluidleitung 74 in Form eines Schlauchs ausgebildet ist, welcher von oben in den Aufnahmeraum 52 des Behälters 50 eingeführt ist. Die Fluidfördereinrichtung 58 umfasst vorzugsweise außerdem eine Pumpeneinrichtung 78 (vgl. Fig. 1, in den Fig. 2a bis 2c nicht dargestellt) zur Förderung des Lithographiefluids 20.

Die Fluidfördereinrichtung 58 ermöglicht es somit nach dem Schreiben einer Teilstruktur 62-1, 62-2, 62-2 oder einer ersten Zielstruktur 60 die Füllhöhe 56 sogar wieder zu erniedrigen, sodass eine nachfolgend geschriebene Teilstruktur oder zweite Zielstruktur auf einem niedrigeren Niveau entlang der optischen Achse 28 geschrieben werden kann.

Die Figur 4 zeigt in vereinfachter schematischer Ansicht eine weitere beispielhafte Ausgestaltung der Fluidfördereinrichtung 58, welche eine Fluidzuführleitung 80 zum Zuführen von Lithographiefluid 20 in den Aufnahmeraum 52 und eine separate Fluidabführleitung 82 zum Abführen von Lithographiefluid 20 aus dem Aufnahmeraum 52 umfasst. Wie aus Figur 4 ersichtlich, umfasst der Behälter 50 dann beispielhaft entsprechende Fluidanschlüsse 76. Die Fluidanschlüsse 76 sind bei dem in Figur 4 dargestellten Beispiel an einander gegenüberliegenden Seiten der Behälterwandung 51 angeordnet. Es ist aber auch möglich, dass die Fluidanschlüsse 76 an der gleichen Seite angeordnet sind.

In dem dargestellten Beispiel sind die Fluidzuführleitung 80 und die Fluidabführleitung 82 mit einem Lithographiefluid-Reservoir 84 verbunden, sodass zusammen mit dem Aufnahmeraum 52 ein Fluidkreislauf gebildet ist. Die Fluidfördereinrichtung 58 gemäß Fig. 4 umfasst insbesondere auch eine Pumpeneinrichtung 78 (nicht dargestellt) zum Fördern des Lithographiefluids 20 entlang des Fluidkreises. Die in Figur 4 dargestellte Ausgestaltung ermöglicht es insofern Lithographiefluid 20 aus dem Aufnahmeraum 52 abzusaugen und, beispielsweise zu einem späteren Zeitpunkt, dem Aufnahmeraum 52 wieder zuzuführen.

Die Figur 5 zeigt eine weitere Ausgestaltung eines Behälters 50, welcher für einen Multimaterialdruck ausgebildet ist. Im dargestellten Beispiel sind an dem Behälter 50 insgesamt vier Fluidanschlüsse 76 vorgesehen, welche mit entsprechenden Fluidleitungen 74-1, 74-2, 74-3, 74-4 verbunden sind. Vorzugsweise bilden zwei Fluidleitungen 74-1, 74-3 Fluidzuführleitungen 80-1, 80-2 und zwei Fluidleitungen 74-2, 74-4 Fluidabführleitungen 82-1, 82-2. Insbesondere können jeweils eine Fluidzuführleitung 80-1, 80-2 und eine Fluidabführleitung 82-1, 82-2 mit einem Lithographiefluid-Reservoir analog zu der in Fig. 4 dargestellten Ausgestaltung verbunden sein. Insofern können insbesondere zwei Fluidkreisläufe vorgesehen sein. Insbesondere kann jeder Fluidkreislauf ein unterschiedliches Lithographiefluid 20 führen, sodass die Zielstruktur 60 aus unterschiedlichen Materialien gefertigt werden kann.

Die Figuren 6a und 6b zeigen schematisch eine Ausgestaltung der Lithographievorrichtung 10, bei welcher die Fokussieroptik 30 als Immersionsobjektiv 46 ausgebildet ist. Bei einer solchen Ausgestaltung ist die Austrittsoberfläche 26 dann zum Schreiben der Zielstruktur 60 in das Lithographiefluid 20 eingetaucht. Ein Abstand 44 zwischen der Austrittsoberfläche 26 und der Oberfläche 42 des Lithographiefluids 20 definiert insofern ein Maß dafür, wie weit das Immersionsobjektiv 46 in das Lithographiefluid 20 eingetaucht ist. Wie in den Fig. 6a und 6b schematisch dargestellt, wird die Füllhöhe 56 des Lithographiefluids 20 vorzugsweise derart angepasst, dass empfindliche Bereiche 86 des Immersionsobjektivs 46 nicht in Kontakt mit dem Lithographiefluid 20 gelangen.

## Patentansprüche

1. Verfahren zum Erzeugen einer dreidimensionalen Zielstruktur (60) in einem Lithographiefluid (20) mittels einer Lithographievorrichtung (10),
die Lithographievorrichtung (10) umfassend
- einen Aufnahmeraum (52) für Lithographiefluid (20) ;
- eine Strahlungsquelle (12) zur Aussendung eines Schreibstrahls (14);
- eine Strahlführungseinrichtung (16) zur Definition eines Strahlengangs (18) für den Schreibstrahl (14) von der Strahlungsquelle (12) zu dem Lithographiefluid (20), umfassend eine Austrittsoptik (24) mit einer Austrittsoberfläche (26), durch welche der Schreibstrahl (14) entlang einer optischen Achse (28) austritt, wobei die Austrittsoptik (24) und/oder der Aufnahmeraum (52) entlang der optischen Achse (28) verlagerbar sind;
- eine Füllhöhe-Einstelleinrichtung (54) zum Verändern einer Füllhöhe (56) des Lithographiefluids (20) in dem Aufnahmeraum (52),
das Verfahren umfassend die Schritte:
- Bereitstellen eines Lithographiefluids (20) in dem Aufnahmeraum (52);
- Einstrahlen des Schreibstrahls (14) in das Lithographiefluid (20) und lokale Verfestigung des Lithographiefluids (20) in einem Fokusbereich (32) des Schreibstrahls (14),
- Verändern der Füllhöhe (56) des Lithographiefluids (20) in dem Aufnahmeraum (52) mittels der Füllhöhe-Einstelleinrichtung (54), um einen Abstand (44) zwischen einer Oberfläche (42) des Lithographiefluids (20) und der Austrittsoberfläche (26) der Austrittsoptik (24) einzustellen.

2. Verfahren nach Anspruch 1, wobei die Füllhöhe (56) des Lithographiefluids (20) in dem Aufnahmeraum (52) in Abhängigkeit einer Relativposition von Aufnahmeraum (52) und Austrittsoptik (24) verändert wird.

3. Verfahren nach einem der vorherigen Ansprüche, wobei die Füllhöhe (56) derart verändert wird, dass während des Einstrahlens des Schreibstrahls (14) in das Lithographiefluid (20) zum Verfestigen des Lithographiefluids (20) der Abstand (44) zwischen der Oberfläche (42) des Lithographiefluids (20) und der Austrittsoberfläche (26) der Austrittsoptik (24) innerhalb eines vorgegebenen oder vorgebbaren Toleranzbereichs (66) um einen Zielabstand liegt, vorzugsweise im Wesentlichen konstant ist.

4. Verfahren nach Anspruch 3, wobei eine Breite (68) des Toleranzbereichs (66) zwischen 0,04 mm und 40 mm, insbesondere zwischen 0,21 mm und 18 mm, weiter insbesondere kleiner 10 mm, weiter insbesondere kleiner 5 mm, insbesondere kleiner 4 mm, weiter insbesondere kleiner 3 mm, weiter insbesondere kleiner 2 mm, weiter insbesondere kleiner 0,5 mm ist.

5. Verfahren nach einem der vorherigen Ansprüche, wobei zum Erzeugen von entlang der optischen Achse (28) erstreckten dreidimensionalen Strukturen (60) eine Relativposition von Austrittsoptik (24) und Aufnahmeraum (52) entlang der optischen Achse (28) verändert wird, wobei die Füllhöhe (56), insbesondere kontinuierlich, während einer Veränderung der Relativposition von Austrittsoptik (24) und Aufnahmeraum (52) verändert wird, insbesondere derart, dass ein Abstand (44) zwischen der Oberfläche (42) des Lithographiefluids (20) und der Austrittsoberfläche (26) im Wesentlichen konstant bleibt.

6. Verfahren nach einem der Ansprüche 1 bis 4, wobei die Zielstruktur (60) dadurch erzeugt wird, dass mehrere Teilstrukturen (62-1, 62-2, 62-3) sequentiell erzeugt werden, welche zusammen die Zielstruktur (60) annähern,
wobei nach dem Erzeugen einer ersten Teilstruktur (62-1) eine zweite Teilstruktur (62-2) erzeugt wird, welche zu der ersten Teilstruktur (62-1), insbesondere entlang der optischen Achse (28), versetzt ist, wobei die Füllhöhe (56) des Lithographiefluids (20) nach dem Erzeugen der ersten Teilstruktur (62-1) um einen vorgegebenen Betrag (64) erhöht oder erniedrigt wird, insbesondere wobei der Betrag (64) zwischen 0,04 mm und 40 mm, weiter insbesondere zwischen 0,21 mm und 18 mm, weiter insbesondere zwischen 1 mm und 5 mm, weiter insbesondere zwischen 1 mm und 3 mm, beträgt.

7. Verfahren nach einem der vorherigen Ansprüche, wobei die Füllhöhe (56) derart eingestellt wird, dass während des Einstrahlens des Schreibstrahls (14) in das Lithographiefluid (20) zum Verfestigen des Lithographiefluids (20) ein erster Teilbereich einer, insbesondere länglich erstrecken, Intensitätsverteilung des Schreibstrahls in dem Fokusbereich unterhalb der Oberfläche (42) des Lithographiefluids (20) angeordnet ist und ein zweiter Teilbereich oberhalb der Oberfläche (42) des Lithographiefluids (20) angeordnet ist.

8. Verfahren nach einem der vorherigen Ansprüche, wobei das Verändern der Füllhöhe (56) des Lithographiefluids (20) das Zuführen von Lithographiefluid (20) in den Aufnahmeraum (52) und/oder das Abführen von Lithographiefluid (20) aus dem Aufnahmeraum (52) umfasst.

9. Verfahren nach einem der vorherigen Ansprüche, wobei ein erstes Lithographiefluid (20) in dem Aufnahmeraum (52) bereitgestellt wird und durch Einstrahlen des Schreibstrahls (14) lokal verfestigt wird, und wobei danach ein zweites Lithographiefluid in dem Aufnahmeraum (52) bereitgestellt wird und durch Einstrahlen des Schreibstrahls (14) lokal verfestigt wird.

10. Verfahren nach dem vorherigen Anspruch, wobei nach dem lokalen Verfestigen des ersten Lithographiefluids (20) und vor dem Bereitstellen des zweiten Lithographiefluids zumindest eine Teilmenge des ersten Lithographiefluids (20) mittels der Füllhöhe-Einstellvorrichtung (54) aus dem Aufnahmeraum (52) entfernt wird.

11. Lithographievorrichtung (10) zum Erzeugen einer dreidimensionalen Zielstruktur (60) in einem Lithographiefluid (20), gemäß einem Verfahren nach einem der vorherigen Ansprüche, umfassend
- einen Aufnahmeraum (52) für das Lithographiefluid (20) ;
- eine Strahlungsquelle (12) zur Aussendung eines Schreibstrahls (14);
- eine Strahlführungseinrichtung (16) zur Definition eines Strahlengangs (18) für den Schreibstrahl (14) von der Strahlungsquelle (12) zu dem Lithographiefluid (20), umfassend eine Austrittsoptik (24) mit einer Austrittsoberfläche (26), durch welche der Schreibstrahl (14) entlang einer optischen Achse (28) austritt, wobei die Austrittsoptik (24) und/oder der Aufnahmeraum (52) entlang der optischen Achse (52) verlagerbar sind;
- eine Füllhöhe-Einstelleinrichtung (54) zum Verändern einer Füllhöhe (56) des Lithographiefluids (20) in dem Aufnahmeraum (52), um einen Abstand (44) zwischen einer Oberfläche (42) des Lithographiefluids (20) und der Austrittsoberfläche (26) der Austrittsoptik (24) einzustellen.

12. Lithographievorrichtung (10) nach dem vorherigen Anspruch, wobei die Füllhöhe-Einstelleinrichtung (54) dazu eingerichtet ist, die Füllhöhe (56) des Lithographiefluids (20) in dem Aufnahmeraum (52), insbesondere in Abhängigkeit einer Relativposition von Aufnahmeraum (52) und Austrittsoptik (24), zu verringern und/oder zu erhöhen.

13. Lithographievorrichtung (10) nach einem der Ansprüche 11 oder 12, wobei die Füllhöhe-Einstelleinrichtung (54) eine Fluidfördereinrichtung (58) umfasst, welche dazu ausgebildet, Lithographiefluid (20) dem Aufnahmebereich (52) zuzuführen und/oder aus dem Aufnahmebereich (52) abzuführen.

14. Lithographievorrichtung (10) nach dem vorherigen Anspruch, wobei die Fluidfördereinrichtung (58) wenigstens eine Fluidleitung (74) und wenigstens eine Pumpeneinrichtung (78) zum Zuführen von Lithographiefluid (20) in den Aufnahmeraum (52) und/oder zum Absaugen von Lithographiefluid (20) aus dem Aufnahmeraum (52) umfasst.

15. Lithographievorrichtung (10) nach einem der Ansprüche 13 oder 14, wobei die Fluidfördereinrichtung (58) wenigstens eine Fluidzuführleitung (80) zum Zuführen von Lithographiefluid (20) in den Aufnahmeraum (52) und wenigstens eine Fluidabführleitung (82) zum Abführen von Lithographiefluid (20) aus dem Aufnahmeraum (52) umfasst, wobei die wenigstens eine Fluidzuführleitung (80) und die wenigstens eine Fluidabführleitung (82) mit einem Lithographiefluid-Reservoir (84) verbunden sind, insbesondere wobei die wenigstens eine Fluidzuführleitung (80) und die wenigstens eine Fluidrückführleitung (82) mit dem Aufnahmeraum (52) und dem Lithographiefluid-Reservoir (84) einen Fluidkreislauf bilden.

16. Lithographievorrichtung (10) nach einem der Ansprüche 12 bis 15, wobei eine Mehrzahl von Fluidzuführleitungen (80-1, 80-2) und eine Mehrzahl von Fluidabführleitungen (82-1, 82-2) vorgesehen sind, wobei ein erstes Paar aus Fluidzuführleitung (80-1) und Fluidabführleitung (82-2) zum Zuführen bzw. Abführen eines ersten Lithographiefluids (20) ausgebildet ist und wobei ein zweites Paar aus Fluidzuführleitung (80-2) und Fluidabführleitung (82-2) zum Zuführen bzw. Abführen eines zweiten Lithographiefluids ausgebildet ist.

17. Lithographievorrichtung (10) nach einem der Ansprüche 11 bis 16, wobei der Aufnahmeraum (52) durch einen Behälter (50) bereitgestellt ist, wobei der Behälter (50) wenigstens einen Fluidanschluss (76) zum Zuführen und/oder Abführen von Lithographiefluid (20) aufweist, insbesondere wenigstens einen Fluidanschluss (76) zum Zuführen von Lithographiefluid (20) und wenigstens einen separaten Fluidanschluss (76) zum Abführen von Lithographiefluid (20) aufweist.

18. Lithographievorrichtung nach einem der Ansprüche 11 bis 17, wobei die Strahlführungseinrichtung (16) eine Fokussieroptik (30) zur Fokussierung des Schreibstrahls (14) in einem Fokusbereich (32) umfasst,
wobei die Fokussieroptik (30) ein Luftobjektiv (40) umfasst, welches die Austrittsoberfläche (26) bereitstellt und derart angeordnet ist, dass die Austrittsoberfläche (26) außerhalb des Lithographiefluids (20) angeordnet ist,
oder
wobei die Fokussieroptik (30) ein Immersionsobjektiv (46) umfasst, welches die Austrittsoberfläche (26) bereitstellt und derart angeordnet ist, dass die Austrittsoberfläche (26) in das Lithographiefluid (20) eingetaucht ist.

19. Lithographievorrichtung (10) nach einem der Ansprüche 11 bis 18, außerdem umfassend eine Sensoreinrichtung zur Erfassung der Füllhöhe (56) des Lithographiefluids (20) in dem Aufnahmeraum (52).

20. Lithographievorrichtung (10) nach einem der Ansprüche 11 bis 19, außerdem umfassend eine Steuereinrichtung zur Ansteuerung der Lithographievorrichtung (10), wobei die Steuereinrichtung dazu eingerichtet ist, ein Verfahren gemäß einem der Ansprüche 1 bis 10 durchzuführen.

## Claims

1. Method for producing a three-dimensional target structure (60) in a lithography fluid (20) by means of a lithography apparatus (10), the lithography apparatus (10) comprising
- a receiving space (52) for lithography fluid (20);
- a radiation source (12) for emitting a writing beam (14) ;
- a beam guiding device (16) for defining a beam path (18) for the writing beam (14) from the radiation source (12) to the lithography fluid (20), comprising an exit optical system (24) having an exit surface (26) through which the writing beam (14) exits along an optical axis (28), wherein the exit optical system (24) and/or the receiving space (52) are displaceable along the optical axis (28);
- a filling level adjustment device (54) for changing a filling level (56) of the lithography fluid (20) in the receiving space (52),
the method comprising the steps of:
- providing a lithography fluid (20) in the receiving space (52);
- irradiating the writing beam (14) into the lithography fluid (20) and locally solidifying the lithography fluid (20) in a focus region (32) of the writing beam (14),
- changing the filling level (56) of the lithography fluid (20) in the receiving space (52) by means of the filling level adjustment device (54) in order to adjust a distance (44) between a surface (42) of the lithography fluid (20) and the exit surface (26) of the exit optical system (24).

2. Method according to claim 1, wherein the filling level (56) of the lithography fluid (20) in the receiving space (52) is changed depending on a relative position of the receiving space (52) and the exit optical system (24) .

3. Method according to any of the preceding claims,
wherein the filling level (56) is changed such that during the irradiation of the writing beam (14) into the lithography fluid (20) for solidifying the lithography fluid (20), the distance (44) between the surface (42) of the lithography fluid (20) and the exit surface (26) of the exit optical system (24) is within a predetermined or predeterminable tolerance range (66) around a target distance, and is preferably substantially constant.

4. Method according to claim 3, wherein a width (68) of the tolerance range (66) is between 0.04 mm and 40 mm, in particular between 0.21 mm and 18 mm, more particularly less than 10 mm, more particularly less than 5 mm, in particular less than 4 mm, more particularly less than 3 mm, more particularly less than 2 mm, more particularly less than 0.5 mm.

5. Method according to any of the preceding claims,
wherein, in order to produce three-dimensional structures (60) extending along the optical axis (28), a relative position of the exit optical system (24) and the receiving space (52) is changed along the optical axis (28), wherein the filling level (56) is changed, in particular continuously, during a change in the relative position of the exit optical system (24) and the receiving space (52), in particular such that a distance (44) between the surface (42) of the lithography fluid (20) and the exit surface (26) remains substantially constant.

6. Method according to any of claims 1 to 4, wherein the target structure (60) is produced by sequentially producing a plurality of partial structures (62-1, 62-2, 62-3) which together approximate the target structure (60),
wherein after producing a first partial structure (62-1), a second partial structure (62-2) is produced, which is offset with respect to the first partial structure (62-1),
in particular along the optical axis (28),
wherein the filling level (56) of the lithography fluid (20) is increased or decreased by a predetermined amount (64) after the production of the first partial structure (62-1), in particular wherein the amount (64) is between 0.04 mm and 40 mm, more particularly between 0.21 mm and 18 mm, more particularly between 1 mm and 5 mm, more particularly between 1 mm and 3 mm.

7. Method according to any of the preceding claims,
wherein the filling level (56) is adjusted such that during the irradiation of the writing beam (14) into the lithography fluid (20) for solidifying the lithography fluid (20), a first portion of an, in particular elongate, intensity distribution of the writing beam in the focus region is arranged below the surface (42) of the lithography fluid (20), and a second portion is arranged above the surface (42) of the lithography fluid (20).

8. Method according to any of the preceding claims,
wherein changing the filling level (56) of the lithography fluid (20) comprises supplying lithography fluid (20) into the receiving space (52) and/or removing lithography fluid (20) from the receiving space (52).

9. Method according to any of the preceding claims,
wherein a first lithography fluid (20) is provided in the receiving space (52) and is locally solidified by irradiation of the writing beam (14), and wherein a second lithography fluid is then provided in the receiving space (52) and is locally solidified by irradiation of the writing beam (14).

10. Method according to the preceding claim, wherein after the local solidification of the first lithography fluid (20) and before the provision of the second lithography fluid, at least some of the first lithography fluid (20) is removed from the receiving space (52) by means of the filling level adjustment device (54).

11. Lithography apparatus (10) for producing a three-dimensional target structure (60) in a lithography fluid (20), according to a method according to any of the preceding claims, comprising
- a receiving space (52) for the lithography fluid (20) ;
- a radiation source (12) for emitting a writing beam (14) ;
- a beam guiding device (16) for defining a beam path (18) for the writing beam (14) from the radiation source (12) to the lithography fluid (20), comprising an exit optical system (24) having an exit surface (26) through which the writing beam (14) exits along an optical axis (28), wherein the exit optical system (24) and/or the receiving space (52) are displaceable along the optical axis (52);
- a filling level adjustment device (54) for changing a filling level (56) of the lithography fluid (20) in the receiving space (52) in order to adjust a distance (44) between a surface (42) of the lithography fluid (20) and the exit surface (26) of the exit optical system (24).

12. Lithography apparatus (10) according to the preceding claim, wherein the filling level adjustment device (54) is designed to reduce and/or increase the filling level (56) of the lithography fluid (20) in the receiving space (52), in particular depending on a relative position of the receiving space (52) and the exit optical system (24).

13. Lithography apparatus (10) according to claim 11 or claim 12, wherein the filling level adjustment device (54) comprises a fluid conveying device (58) which is designed to supply lithography fluid (20) to the receiving region (52) and/or to discharge lithography fluid from the receiving region (52).

14. Lithography apparatus (10) according to the preceding claim, wherein the fluid conveying device (58) comprises at least one fluid line (74) and at least one pumping device (78) for supplying lithography fluid (20) into the receiving space (52) and/or for suctioning lithography fluid (20) from the receiving space (52).

15. Lithography apparatus (10) according to claim 13 or claim 14, wherein the fluid conveying device (58) comprises at least one fluid supply line (80) for supplying lithography fluid (20) into the receiving space (52) and at least one fluid discharge line (82) for discharging lithography fluid (20) from the receiving space (52), wherein the at least one fluid supply line (80) and the at least one fluid discharge line (82) are connected to a lithography fluid reservoir (84), in particular wherein the at least one fluid supply line (80) and the at least one fluid return line (82) form a fluid circuit together with the receiving space (52) and the lithography fluid reservoir (84).

16. Lithography apparatus (10) according to any of claims 12 to 15, wherein a plurality of fluid supply lines (80-1, 80-2) and a plurality of fluid discharge lines (82-1, 82-2) are provided, wherein a first pair of a fluid supply line (80-1) and a fluid discharge line (82-2) is designed to supply and discharge a first lithography fluid (20) and wherein a second pair of a fluid supply line (80-2) and a fluid discharge line (82-2) is designed to supply and discharge a second lithography fluid.

17. Lithography apparatus (10) according to any of claims 11 to 16, wherein the receiving space (52) is provided by a container (50), wherein the container (50) has at least one fluid connection (76) for supplying and/or discharging lithography fluid (20), in particular at least one fluid connection (76) for supplying lithography fluid (20) and at least one separate fluid connection (76) for discharging lithography fluid (20).

18. Lithography apparatus according to any of claims 11 to 17, wherein the beam guiding device (16) comprises a focusing optical system (30) for focusing the writing beam (14) in a focus region (32),
wherein the focusing optical system (30) comprises an air objective (40) which provides the exit surface (26) and is arranged such that the exit surface (26) is arranged outside the lithography fluid (20),
or
wherein the focusing optical system (30) comprises an immersion objective (46) which provides the exit surface (26)
and is arranged such that the exit surface (26) is immersed in the lithography fluid (20).

19. Lithography apparatus (10) according to any of claims 11 to 18, further comprising a sensor device for detecting the filling level (56) of the lithography fluid (20) in the receiving space (52).

20. Lithography apparatus (10) according to any of claims 11 to 19, further comprising a control device for controlling the lithography apparatus (10), wherein the control device is configured to carry out a method according to any of claims 1 to 10.

## Revendications

1. Procédé permettant de générer une structure cible tridimensionnelle (60) dans un liquide pour lithographie (20) au moyen d'un dispositif de lithographie (10), le dispositif de lithographie (10) comprenant
- un espace de réception (52) pour le liquide pour lithographie (20);
- une source de rayonnement (12) permettant d'émettre un faisceau d'écriture (14);
- un appareil de guidage de faisceau (16) permettant de définir une trajectoire de faisceau (18) pour le faisceau d'écriture (14) de la source de rayonnement (12) au liquide pour lithographie (20), comprenant une optique de sortie (24) comportant une surface de sortie (26) à travers laquelle le faisceau d'écriture (14) sort le long d'un axe optique (28), dans lequel l'optique de sortie (24) et/ou l'espace de réception (52) peuvent être déplacés le long de l'axe optique (28);
- un appareil de réglage de niveau de remplissage (54) permettant de modifier un niveau de remplissage (56) du liquide pour lithographie (20) dans l'espace de réception (52),
le procédé comprenant les étapes consistant à:
- fournir un liquide pour lithographie (20) dans l'espace de réception (52);
- irradier le faisceau d'écriture (14) dans le liquide pour lithographie (20) et solidifier localement le liquide pour lithographie (20) dans une zone focale (32) du faisceau d'écriture (14),
- modifier le niveau de remplissage (56) du liquide pour lithographie (20) dans l'espace de réception (52) au moyen de l'appareil de réglage de niveau de remplissage (54) afin de régler une distance (44) entre une surface (42) du liquide pour lithographie (20) et la surface de sortie (26) de l'optique de sortie (24).

2. Procédé selon la revendication 1, dans lequel le niveau de remplissage (56) du liquide pour lithographie (20) dans l'espace de réception (52) est modifié en fonction d'une position relative de l'espace de réception (52) et de l'optique de sortie (24).

3. Procédé selon l'une des revendications précédentes, dans lequel le niveau de remplissage (56) est modifié de telle sorte que, pendant l'irradiation du faisceau d'écriture (14) dans le liquide pour lithographie (20) pour la solidification du liquide pour lithographie (20), la distance (44) entre la surface (42) du liquide pour lithographie (20) et la surface de sortie (26) de l'optique de sortie (24) se situe à l'intérieur d'une plage de tolérance (66) prédéfinie ou pouvant être prédéfinie autour d'une distance cible, et est de préférence sensiblement constante.

4. Procédé selon la revendication 3, dans lequel une largeur (68) de la plage de tolérance (66) est comprise entre 0,04 mm et 40 mm, en particulier entre 0,21 mm et 18 mm, plus particulièrement inférieure à 10 mm, plus particulièrement inférieure à 5 mm, en particulier inférieure à 4 mm, plus particulièrement inférieure à 3 mm, plus particulièrement inférieure à 2 mm, plus particulièrement inférieure à 0,5 mm.

5. Procédé selon l'une des revendications précédentes, dans lequel, pour la génération de structures tridimensionnelles (60) s'étendant le long de l'axe optique (28), une position relative de l'optique de sortie (24) et de l'espace de réception (52) est modifiée le long de l'axe optique (28), dans lequel le niveau de remplissage (56) est modifié, en particulier en continu, pendant une modification de la position relative de l'optique de sortie (24) et de l'espace de réception (52), en particulier de telle sorte qu'une distance (44) entre la surface (42) du liquide pour lithographie (20) et la surface de sortie (26) reste sensiblement constante.

6. Procédé selon l'une des revendications 1 à 4, dans lequel la structure cible (60) est générée en générant séquentiellement plusieurs structures partielles (62-1, 62-2, 62-3) qui, conjointement, se rapprochent de la structure cible (60),
dans lequel, après la génération d'une première structure partielle (62-1), une seconde structure partielle (62-2) est générée, laquelle est décalée par rapport à la première structure partielle (62-1),
en particulier le long de l'axe optique (28),
dans lequel le niveau de remplissage (56) du liquide pour lithographie (20) est augmenté ou diminué d'une valeur (64) prédéfinie après la génération de la première structure partielle (62-1), en particulier dans lequel la valeur (64) est comprise entre 0,04 mm et 40 mm, plus particulièrement entre 0,21 mm et 18 mm, plus particulièrement entre 1 mm et 5 mm, plus particulièrement entre 1 mm et 3 mm.

7. Procédé selon l'une des revendications précédentes, dans lequel le niveau de remplissage (56) est réglé de telle sorte que, pendant l'irradiation du faisceau d'écriture (14) dans le liquide pour lithographie (20) pour la solidification du liquide pour lithographie (20), une première zone partielle d'une répartition d'intensité, en particulier étendue de manière oblongue, du faisceau d'écriture est disposée dans la zone focale en dessous de la surface (42) du liquide pour lithographie (20) et une seconde zone partielle est disposée au-dessus de la surface (42) du liquide pour lithographie (20).

8. Procédé selon l'une des revendications précédentes, dans lequel la modification du niveau de remplissage (56) du liquide pour lithographie (20) comprend l'alimentation en liquide pour lithographie (20) de l'espace de réception (52) et/ou l'évacuation du liquide pour lithographie (20) hors de l'espace de réception (52).

9. Procédé selon l'une des revendications précédentes, dans lequel un premier liquide pour lithographie (20) est fourni dans l'espace de réception (52) et est solidifié localement par irradiation du faisceau d'écriture (14), et dans lequel un second liquide pour lithographie est ensuite fourni dans l'espace de réception (52) et est solidifié localement par irradiation du faisceau d'écriture (14).

10. Procédé selon la revendication précédente, dans lequel, après la solidification locale du premier liquide pour lithographie (20) et avant la fourniture du second liquide pour lithographie, au moins une quantité partielle du premier liquide pour lithographie (20) est retirée de l'espace de réception (52) au moyen du dispositif de réglage de niveau de remplissage (54).

11. Dispositif de lithographie (10) permettant de générer une structure cible tridimensionnelle (60) dans un liquide pour lithographie (20), selon un procédé selon l'une des revendications précédentes, comprenant
- un espace de réception (52) pour le liquide pour lithographie (20);
- une source de rayonnement (12) permettant d'émettre un faisceau d'écriture (14);
- un appareil de guidage de faisceau (16) permettant de définir une trajectoire de faisceau (18) pour le faisceau d'écriture (14) de la source de rayonnement (12) au liquide pour lithographie (20), comprenant une optique de sortie (24) comportant une surface de sortie (26) à travers laquelle le faisceau d'écriture (14) sort le long d'un axe optique (28), dans lequel l'optique de sortie (24) et/ou l'espace de réception (52) peuvent être déplacés le long de l'axe optique (52);
- un appareil de réglage de niveau de remplissage (54) permettant de modifier un niveau de remplissage (56) du liquide pour lithographie (20) dans l'espace de réception (52) afin de régler une distance (44) entre une surface (42) du liquide pour lithographie (20) et la surface de sortie (26) de l'optique de sortie (24).

12. Dispositif de lithographie (10) selon la revendication précédente, dans lequel l'appareil de réglage de niveau de remplissage (54) est configuré pour diminuer et/ou augmenter le niveau de remplissage (56) du liquide pour lithographie (20) dans l'espace de réception (52), en particulier en fonction d'une position relative de l'espace de réception (52) et de l'optique de sortie (24) .

13. Dispositif de lithographie (10) selon l'une des revendications 11 ou 12, dans lequel l'appareil de réglage de niveau de remplissage (54) comprend un appareil d'acheminement de liquide (58) configuré pour alimenter la zone de réception (52) en liquide pour lithographie (20) et/ou pour l'évacuer de la zone de réception (52).

14. Dispositif de lithographie (10) selon la revendication précédente, dans lequel l'appareil d'acheminement de liquide (58) comprend au moins une conduite de liquide (74) et au moins un appareil de pompage (78) permettant d'alimenter l'espace de réception (52) en liquide pour lithographie (20) et/ou permettant d'aspirer le liquide pour lithographie (20) hors de l'espace de réception (52) .

15. Dispositif de lithographie (10) selon l'une des revendications 13 ou 14, dans lequel l'appareil d'acheminement de liquide (58) comprend au moins une conduite d'alimentation en liquide (80) permettant l'alimentation de l'espace de réception (52) en liquide pour lithographie (20) et au moins une conduite d'évacuation de liquide (82) permettant d'évacuer le liquide pour lithographie (20) de l'espace de réception (52), dans lequel l'au moins une conduite d'alimentation en liquide (80) et l'au moins une conduite d'évacuation de liquide (82) sont raccordées à un réservoir de liquide pour lithographie (84), en particulier dans lequel l'au moins une conduite d'alimentation en liquide (80) et l'au moins une conduite d'évacuation de liquide (82) forment un circuit pour liquide avec l'espace de réception (52) et le réservoir de liquide pour lithographie (84).

16. Dispositif de lithographie (10) selon l'une des revendications 12 à 15, dans lequel une pluralité de conduites d'alimentation en liquide (80-1, 80-2) et une pluralité de conduites d'évacuation de liquide (82-1, 82-2) sont prévues, dans lequel une première paire de conduite d'alimentation en liquide (80-1) et de conduite d'évacuation de liquide (82-2) est réalisée pour l'alimentation en un premier liquide pour lithographie (20) ou son évacuation, et dans lequel une seconde paire de conduite d'alimentation en liquide (80-2) et de conduite d'évacuation de liquide (82-2) est réalisée pour l'alimentation en un second liquide pour lithographie ou son évacuation.

17. Dispositif de lithographie (10) selon l'une des revendications 11 à 16, dans lequel l'espace de réception (52) est fourni par un récipient (50), dans lequel le récipient (50) présente au moins un raccord pour liquide (76) permettant l'alimentation en liquide pour lithographie (20) et/ou son évacuation, en particulier présente au moins un raccord pour liquide (76) permettant l'alimentation en liquide pour lithographie (20) et au moins un raccord pour liquide (76) séparé permettant l'évacuation du liquide pour lithographie (20).

18. Dispositif de lithographie selon l'une des revendications 11 à 17, dans lequel l'appareil de guidage de faisceau (16) comprend une optique focalisatrice (30) permettant de focaliser le faisceau d'écriture (14) dans une zone focale (32),
dans lequel l'optique focalisatrice (30) comprend un objectif à air (40) qui fournit la surface de sortie (26) et est disposé de telle sorte que la surface de sortie (26) est disposée à l'extérieur du liquide pour lithographie (20),
ou
dans lequel l'optique focalisatrice (30) comprend un objectif à immersion (46) qui fournit la surface de sortie (26)
et est disposé de telle sorte que la surface de sortie (26) est immergée dans le liquide pour lithographie (20) .

19. Dispositif de lithographie (10) selon l'une des revendications 11 à 18, comprenant en outre un appareil de détection permettant de détecter le niveau de remplissage (56) du liquide pour lithographie (20) dans l'espace de réception (52).

20. Dispositif de lithographie (10) selon l'une des revendications 11 à 19, comprenant en outre un appareil de commande permettant de commander le dispositif de lithographie (10), dans lequel l'appareil de commande est configuré pour mettre en œuvre un procédé selon l'une des revendications 1 à 10.
